# EUROPEAN PATENT APPLICATION

(11) **EP 4 575 599 A1**
(43) Date of publication of application: **25.06.2025**
(21) Application number: 23867081.4
(22) Date of filing: 30.06.2023
(51) Int. Cl.: G02B 6/42

(54) **OPTICAL TRANSCEIVER MODULE AND COMMUNICATION DEVICE**

(30) Priority: 20.09.2022 CN 202211142702
(71) Applicant: Huawei Technologies Co., Ltd., Shenzhen, Guangdong 518129 (CN)
(72) Inventor: CHENG, Ming, Shenzhen, Guangdong 518129 (CN); ZOU, Sihua, Shenzhen, Guangdong 518129 (CN); YANG, Chengpeng, Shenzhen, Guangdong 518129 (CN)
(74) Representative: Isarpatent
(86) International application number: PCT/CN2023/105372
(87) International publication number: WO 2024/060786

(57) **Abstract**

Embodiments of this application provide an optical transceiver module and a communication device. The optical transceiver module includes a housing, a substrate, and a chip and an optical component that are mounted on the substrate. The housing has a receptacle that accommodates the chip, the optical component, and the substrate, and a top wall of the housing has a first region and a second region that are heat-insulated from each other. One of the chip and the optical component dissipates heat outside the housing through the first region, and the other of the chip and the optical component dissipates heat outside the housing through the second region. The first region and the second region that are heat-insulated from each other are used to dissipate heat for the optical component and the chip. This can avoid difficulty in heat dissipation of the optical component caused when heat generated by the chip bakes the optical component, and helps improve a heat dissipation capability of the optical transceiver module.

## Description

This application claims priority to Chinese Patent Application No. 202211142702.4, filed with the China National Intellectual Property Administration on September 20, 2022 and entitled "OPTICAL TRANSCEIVER MODULE AND COMMUNICATION DEVICE", which is incorporated herein by reference in its entirety.

### TECHNICAL FIELD

Embodiments of this application relate to the field of communication technologies, and in particular, to an optical transceiver module and a communication device.

### BACKGROUND

In a communication network, an optical module is a functional module that implements mutual conversion between an optical signal and an electrical signal. In a use process of the optical module, each heating component of the optical module generates heat, causing an excessively high temperature of the optical module. Therefore, to ensure normal use of the optical module, the optical module needs to dissipate heat. The heating component may be a component such as an electrical chip or an optical component.

In a related technology, a heat sink is used to dissipate heat for the optical module. In addition, a heat conduction layer made of a heat conduction material is disposed on a surface of an upper cover of the optical module, and the upper cover is attached to the heat sink through the heat conduction layer, to dissipate heat for the entire optical module. However, a heat dissipation effect of the heat sink on the optical module is poor, and the optical module still has a problem of difficulty in heat dissipation.

### SUMMARY

Embodiments of this application provide an optical transceiver module and a communication device. The optical transceiver module can reduce baking of an optical component caused when heat generated by an electrical chip is transferred to the optical component. In this way, heat dissipation performance of the optical transceiver module can be improved.

A first aspect of this application provides an optical transceiver module. The optical transceiver module includes a housing, a substrate, and a chip and an optical component that are mounted on the substrate. The housing has a receptacle that accommodates the chip, the optical component, and the substrate, and a top wall of the housing has a first region and a second region that are heat-insulated from each other. One of the chip and the optical component dissipates heat outside the housing through the first region, and the other of the chip and the optical component dissipates heat outside the housing through the second region.

When the optical transceiver module in this embodiment of this application is used, because the chip dissipates heat outside the housing through one of the first region and the second region, the optical component dissipates heat outside the housing through the other of the first region and the second region, and the first region and the second region are heat-insulated from each other, a large part of heat generated by the chip is transferred outside the housing, and is not transferred to the optical component through the top wall. This can avoid difficulty in heat dissipation of the optical component caused when heat generated by the chip bakes the optical component. Therefore, heat dissipation performance of the optical transceiver module can be improved by using the first region and the second region that are heat-insulated from each other.

In a possible implementation, a heat sink is further included. The heat sink is mounted on the housing and is configured to dissipate heat for one of the chip and the optical component. In this way, heat dissipation performance of the optical transceiver module can be improved.

In a possible implementation, the first region is a through opening that penetrates the top wall, and the through opening communicates with the receptacle. The heat sink is disposed at an interval from the top wall along a height direction of the optical transceiver module, the heat sink exchanges heat with one of the chip and the optical component through a boss portion that passes through the through opening, and there is a gap between a side wall of the boss portion and an inner wall of the through opening. The other of the chip and the optical component is in contact with an inner side surface of the top wall in the second region. In this way, the heat sink can dissipate heat for one of the chip and the optical component, so that a heat dissipation requirement of the optical transceiver module can be met.

In a possible implementation, a heat insulation layer is further included. The heat insulation layer is disposed between the heat sink and the top wall in the second region. The heat insulation layer can improve a heat insulation effect between the heat sink and the top wall, and help further reduce heat transferred from the chip to the optical component through the top wall, to avoid difficulty in heat dissipation caused by baking of the optical component.

In a possible implementation, an elastic fastening member is further included. The heat sink is provided with a first through hole that penetrates the heat sink. The elastic fastening member includes a fastening portion and an elastic portion. A first end of the fastening portion passes through the first through hole and is fastened to the housing, a second end of the fastening portion presses against a top end surface of the heat sink by using the elastic portion, and a bottom end surface of the heat sink is disposed at an interval from the top wall in the height direction of the optical transceiver module. The elastic portion is configured to enable the boss portion to press against one of the chip and the optical component. The elastic fastening member not only mounts the heat sink on the housing, but may also enable the boss portion to press against one of the chip and the optical component, so that a heat dissipation capability of the heat sink can be improved. In addition, when a heat conduction layer made of a heat conduction material is disposed between the boss portion and one of the chip and the optical component, a thickness of the heat conduction layer may be reduced. This helps improve a heat dissipation capability.

In a possible implementation, the elastic fastening member further includes a pressing portion disposed on the fastening portion. The top wall is provided with a second through hole that communicates with the receptacle. The fastening portion passes through the second through hole and is fastened to the housing. The pressing portion is configured to press against the substrate, so that the bottom end surface of the heat sink is disposed at an interval from the top wall in the height direction of the optical transceiver module. The pressing portion presses against the substrate, so that the heat sink can be prevented from being in contact with the top wall in the second region. Heat transferred from the heat sink to the top wall can be reduced, to avoid baking of the optical component caused when heat on the heat sink is transferred to the optical component through the top wall.

In a possible implementation, a limiting post and a fixing screw are further included. The limiting post is disposed between the heat sink and the top wall, and separately presses against the top wall and the heat sink, so that a bottom end surface of the heat sink is disposed at an interval from the top wall in the height direction of the optical transceiver module. The heat sink is fastened to the housing by using the fixing screw. In this way, one on hand, the heat sink can be mounted on the housing, and on the other hand, the heat transferred from the heat sink to the top wall can be reduced.

In a possible implementation, a heat sink fin portion is disposed on an outer side surface of the top wall in the second region, and the heat sink fin portion is disposed at an interval from the heat sink in the height direction of the optical transceiver module. By using the heat sink fin portion, a heat exchange area between the top wall in the second region and air outside the housing can be increased, and a heat dissipation capability can be improved.

In a possible implementation, a first heat conduction layer and a second heat conduction layer are further included. The first heat conduction layer covers a surface of the chip and is configured to exchange heat with the boss portion or the top wall in the second region. The second heat conduction layer covers a surface of the optical component and is configured to exchange heat with the boss portion or the top wall in the second region. In this way, heat dissipation capabilities of the optical component and the chip can be improved.

In a possible implementation, the chip of the chip and the optical component is in contact with the boss portion, and the optical component of the chip and the optical component is in contact with the inner side surface of the top wall in the second region. Because the heat generated by the chip is greater than heat generated by the optical component, the heat sink is used to dissipate heat for the chip, so that an excessively high temperature of the chip can be avoided, and heat dissipation performance of the optical transceiver module can be improved.

In a possible implementation, one of the chip and the optical component is in contact with an inner side surface of the top wall in the first region, and the other of the chip and the optical component is in contact with an inner side surface of the top wall in the second region. In this way, different parts of the top wall can transfer the heat generated by the chip and heat generated by the optical component outside the housing, to meet heat dissipation requirements of the chip and the optical component. In addition, the heat generated by the chip can be reduced and then transferred to the optical component, to prevent the optical component from being baked.

In a possible implementation, the top wall is provided with a heat insulation hole that communicates with the receptacle, and the heat insulation hole is provided between the first region and the second region. Compared with a heat insulation material, air in the heat insulation hole may increase a threshold for heat exchange between the first region and the second region, so that a large part of the heat generated by the chip is dissipated outside the housing instead of being transferred to the optical component.

In a possible implementation, the top wall further includes a heat insulation portion made of a heat insulation material, and the heat insulation portion is disposed between the first region and the second region. The heat insulation portion is made of the heat insulation material, and may increase a threshold for heat exchange between the first region and the second region, so that a large part of the heat generated by the chip is dissipated outside the housing instead of being transferred to the optical component.

A second aspect of this application provides a communication device, including a board and the optical transceiver module according to the first aspect. The optical transceiver module is mounted on the board.

### BRIEF DESCRIPTION OF DRAWINGS

FIG. 1 is a sectional view of a communication device according to this application;
FIG. 2 is a sectional view of an optical transceiver module in a related technology;
FIG. 3 is a sectional view of a first optical transceiver module according to an embodiment of this application;
FIG. 4 is a top view of the optical transceiver module without a heat sink according to the embodiment shown in FIG. 3;
FIG. 5 is a diagram of a structure of an elastic fastening member according to an embodiment of this application;
FIG. 6 is a sectional view of cooperation between a chip and a boss portion according to an embodiment of this application;
FIG. 7 is another sectional view of cooperation between a chip and a boss portion according to an embodiment of this application;
FIG. 8 is a sectional view of a second optical transceiver module according to an embodiment of this application;
FIG. 9 is a sectional view of a third optical transceiver module according to an embodiment of this application;
FIG. 10 is a sectional view of a fourth optical transceiver module according to an embodiment of this application;
FIG. 11 is a sectional view of a fifth optical transceiver module according to an embodiment of this application;
FIG. 12 is a sectional view of a sixth optical transceiver module according to an embodiment of this application;
FIG. 13 is a sectional view of a seventh optical transceiver module according to an embodiment of this application;
FIG. 14 is a top view of a first top wall according to an embodiment of this application;
FIG. 15 is a top view of a second top wall according to an embodiment of this application;
FIG. 16 is a sectional view of a third top wall according to an embodiment of this application;
FIG. 17 is a top view of a fourth top wall according to an embodiment of this application; and
FIG. 18 is a sectional view of an eighth optical transceiver module according to an embodiment of this application.

Descriptions of reference numerals:
10. Optical transceiver module;
11. Housing; 111. Top wall; 112. Receptacle; 113. Second through hole; 114. Upper cover; 115. Bottom case;
12. Substrate; 121. Third through hole;
13. Chip; 131. Substrate layer; 132. Silicon wafer layer; 133. Encapsulation layer;
14. Optical component;
15. First region; 15A. Through opening;
16. Second region;
17. Heat sink; 171. First through hole; 172. Main body portion; 173. Sheet-like portion;
18. Boss portion;
19. Heat insulation layer;
201. Limiting post;
202. Fixing screw;
21. Heat sink fin portion; 211. Connecting sheet; 212. Heat sink sheet;
22. First heat conduction layer;
23. Second heat conduction layer;
24. Heat insulation portion;
25. Fastening nut;
26. Heat insulation hole;
30. Elastic fastening member; 31. Fastening portion; 32. Elastic portion; 33. Pressing portion;
34. Spring;
35. Fastening screw; 351. Stop step surface; 352. Screw cap; 353. Screw bolt; 354. Screw head;
41. Electrical chip; 42. Circuit board; 43. Copper upper cover; 44. Copper base; 45. External heat conduction layer;
50. Board;
100. Communication device;
X. Length direction;
Y. Width direction; and
Z. Height direction.

### DESCRIPTION OF EMBODIMENTS

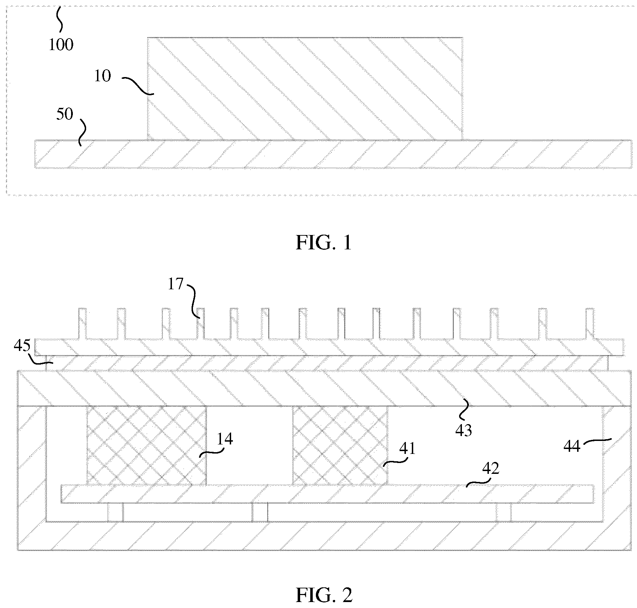

As shown in FIG. 1, in this embodiment of this application, a communication device 100 may include an optical transceiver module 10 and a board 50. The optical transceiver module 10 is mounted on the board 50. The optical transceiver module 10 is configured to implement mutual conversion between an optical signal and an electrical signal, so that data transmission can be met, and in addition, use of the communication device 100 can be met. However, the optical transceiver module 10 generates heat in a use process. To ensure normal use of the optical transceiver module 10, a temperature of the optical transceiver module 10 needs to be within a proper range. Therefore, a heat dissipation structure needs to be disposed on the optical transceiver module 10, to improve heat dissipation performance of the optical transceiver module 10.

In a related technology, as shown in FIG. 2, an optical transceiver module 10 includes an electrical chip 41, a circuit board 42, an optical component 14, a copper upper cover 43, a copper base 44, an external heat conduction layer 45, and a heat sink 17. The copper upper cover 43 is disposed on a top end of the copper base 44 and defines a cavity together with the copper base 44. The optical component 14 is an optoelectronic component that implements mutual conversion between an optical signal and an electrical signal. The electrical chip 41 is configured to control conversion of an optical signal into an electrical signal. The optical component 14, the electrical chip 41, and a substrate 12 are all disposed in the cavity. The optical component 14 and the electrical chip 41 are mounted on a same surface of the circuit board 42. The optical component 14 and the electrical chip 41 are separately in contact with an inner side surface of the copper upper cover 43. The heat sink 17 is in contact with an outer side surface of the copper upper cover 43 through the external heat conduction layer 45. In a use process of the optical transceiver module 10, heat generated by the electrical chip 41 and the optical component 14 is transferred to the copper upper cover 43, then the copper upper cover 43 transfers the heat to the heat sink 17 through the external heat conduction layer 45, and the heat sink 17 transfers the heat to air, to implement heat dissipation of the entire optical transceiver module 10. However, because both the optical component 14 and the electrical chip 41 are in contact with the inner side surface of the copper upper cover 43, a part of heat generated by the electrical chip 41 is transferred to the optical component 14 through the copper upper cover 43, and the optical component 14 is baked. As a result, a temperature of the optical component 14 is excessively high, and heat dissipation of the optical component 14 is difficult. In this case, heat dissipation of the entire optical transceiver module 10 is still difficult.

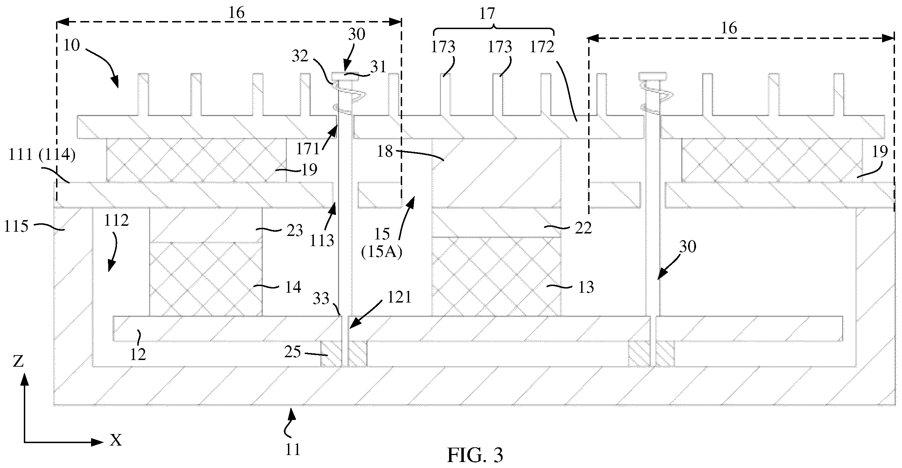

In view of this, an embodiment of this application provides an optical transceiver module 10. Refer to FIG. 3. The optical transceiver module 10 may include a housing 11 that has a receptacle 112, and an optical component 14, a chip 13, and a substrate 12 that are located in the receptacle 112. The chip 13 and the optical component 14 are mounted on the substrate 12. A top wall 111 of the housing 11 has a first region 15 and a second region 16 that are heat-insulated from each other. The chip 13 may dissipate heat outside the housing 11 through the first region 15, and the optical component 14 may dissipate heat outside the housing 11 through the second region 16. Because the first region 15 and the second region 16 are heat-insulated from each other, heat generated by the chip 13 can be prevented from being transferred to the optical component 14 through the top wall 111 of the housing 11 and therefore can be prevented from baking the optical component 14. In this way, a heat dissipation capability of the optical component 14 can be improved, and a heat dissipation capability of the optical transceiver module 10 can be further improved.

It should be noted that, in this embodiment of this application, a definition of heat insulation is not to completely insulate heat transfer, but to insulate a large part of heat transfer. In other words, thermal resistance between two objects that transfer heat to each other is very large, so that heat transferred between the two objects is very small, which is approximately complete heat transfer insulation. Therefore, in this embodiment of this application, thermal resistance between the first region 15 and the second region 16 is very high, and heat transferred between the first region 15 and the second region 16 can be reduced, so that only a small amount of heat can be transferred between the first region 15 and the second region 16, and the transferred heat is insufficient for baking the optical component 14. Therefore, the heat generated by the chip 13 does not affect heat dissipation of the optical component 14.

In addition, in this embodiment of this application, the chip 13 is configured to control conversion of an optical signal into an electrical signal. Therefore, the chip 13 may also be referred to as an electrical chip. This is not specifically limited herein.

The following describes an implementation of the optical transceiver module 10 provided in embodiments of this application.

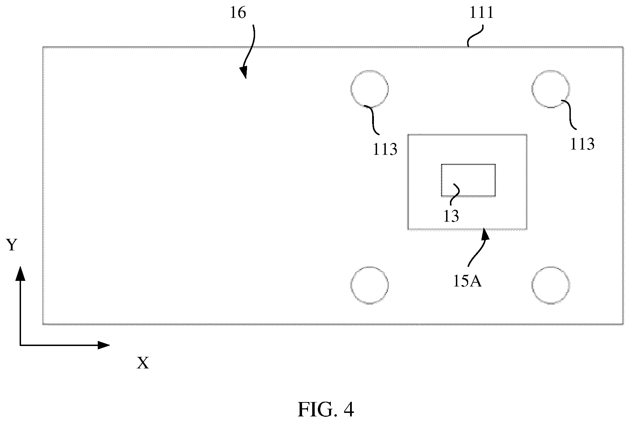

FIG. 3 is a sectional view of a first optical transceiver module according to an embodiment of this application. FIG. 4 is a top view of the optical transceiver module without a heat sink according to the embodiment shown in FIG. 3. As shown in FIG. 3, in this embodiment of this application, the optical transceiver module 10 includes a heat sink 17, a housing 11, a substrate 12, and a chip 13 and an optical component 14 that are mounted on the substrate 12. The housing 11 has a receptacle 112 that accommodates the chip 13, the optical component 14, and the substrate 12, and a top wall 111 of the housing 11 has a first region 15 and a second region 16 that are heat-insulated from each other. The first region 15 is a through opening 15A that penetrates the top wall 111, and the through opening 15A communicates with the receptacle 112. The second region 16 is a region other than the through opening 15A of the top wall 111. The optical component 14 is configured to be in contact with an inner side surface of the top wall 111 in the second region 16. The heat sink 17 is mounted on the housing 11, and is disposed at an interval from the top wall 111 along a height direction (for example, a Z direction in FIG. 3) of the optical transceiver module 10. A boss portion 18 passes through the through opening 15A, and the heat sink 17 is in contact with the chip 13 through the boss portion 18 that passes through the through opening 15A. There is a gap between a side wall of the boss portion 18 and an inner wall of the through opening 15A.

Because there is the gap between the side wall of the boss portion 18 and the inner wall of the through opening 15A, when heat generated by the chip 13 is transferred to the heat sink 17 through the boss portion 18, the heat transferred by the boss portion 18 is not transferred to the top wall 111 in the second region 16. The heat generated by the chip 13 can be prevented from being transferred to the optical component 14 through the top wall in the second region 16, to prevent the optical component 14 from being baked. In addition, the heat sink 17 is disposed at an interval from the top wall 111 in the height direction of the optical transceiver module 10, so that the heat sink 17 is not in contact with the top wall 111. This can prevent heat on the heat sink 17 from being transferred to the top wall 111 in the second region 16 and therefore can prevent the optical component 14 from being baked. Therefore, through cooperation of the through opening 15A, the boss portion 18, and the heat sink 17, the heat sink 17 can separately dissipate heat for the chip 13, can prevent the heat generated by the chip 13 from being transferred to the optical component 14, and can prevent the optical component 14 from being baked by the heat of the chip 13. In this way, the optical component 14 can dissipate heat outside the housing 11 through the top wall 111 in the second region 16, and a heat dissipation capability of the optical component 14 can be further improved.

A shape of the through opening 15A may be a circle, a rectangle, a polygon, or the like. This is not limited herein. Refer to FIG. 4. For example, the shape of the through opening 15A is a rectangle. In addition, an opening size of the through opening 15A is larger than a size of the chip 13, so that the chip 13 is exposed to the through opening 15A. This helps increase a contact area between the boss portion 18 and the chip 13.

The boss portion 18 may be a part of the heat sink 17, that is, the boss portion 18 and the heat sink 17 are in an integrated structure. Certainly, the boss portion 18 may alternatively be a separately disposed part, and the boss portion 18 is detachably connected to the heat sink 17, so that the boss portion 18 and the heat sink 17 form a split structure. In addition, a shape of the boss portion 18 may depend on a shape of the chip 13. This is not specifically limited herein. For example, when the shape of the chip 13 is a square, the boss portion 18 may be a square prism. In addition, a material of the boss portion 18 is a heat conduction material. For example, the material of the boss portion 18 may be copper.

It should be noted that, because power consumption of the chip 13 may account for 70% of power consumption of the optical transceiver module 10, and power consumption of the optical component 14 is low, the heat generated by the chip 13 is greater than heat generated by the optical component 14. The heat sink 17 dissipates heat for the chip 13, so that a heat dissipation capability of the chip 13 can be improved. This helps improve a heat dissipation capability of the optical transceiver module 10.

Still refer to FIG. 3. The optical transceiver module 10 may further include a heat insulation layer 19, which is disposed between the heat sink 17 and the top wall 111 in the second region 16. The heat insulation layer 19 may increase thermal resistance between the heat sink 17 and the top wall 111 in the second region 16, and may further reduce heat transferred from the heat sink 17 to the top wall 111. In this way, the optical component 14 can be prevented from being baked by the heat on the heat sink 17. This helps improve the heat dissipation capability of the optical component 14. The heat insulation layer 19 may be made of a heat insulation material. For example, a material of the heat insulation layer 19 is a compressible material with a low thermal conductivity coefficient. For example, the material of the heat insulation layer 19 is silicone rubber.

It should be noted that the heat insulation layer 19 may alternatively be removed, but the heat sink 17 is disposed at an interval from the top wall 111 in the second region 16 in the height direction of the optical transceiver module 10, to prevent the heat sink 17 from being in contact with the top wall 111 in the second region 16. In other words, the material of the heat insulation layer 19 may be air, and the thermal resistance between the heat sink 17 and the top wall 111 is increased by air, to reduce the heat transferred from the heat sink 17 to the top wall 111.

Still refer to FIG. 3. The optical transceiver module 10 may further include a first heat conduction layer 22 and a second heat conduction layer 23. The first heat conduction layer 22 covers a surface of the chip 13 and is in contact with the boss portion 18. The first heat conduction layer 22 can increase a speed of transferring the heat of the chip 13 to the boss portion 18. This helps improve the heat dissipation capability of the chip 13. The second heat conduction layer 23 covers a surface of the optical component 14 and is in contact with the inner side surface of the top wall 111. The second heat conduction layer 23 can increase a speed of transferring heat of the optical component 14 to the top wall 111. This helps improve the heat dissipation capability of the optical component 14. A material of the first heat conduction layer 22 and a material of the second heat conduction layer 23 are both heat conduction materials. For example, the material of either of the first heat conduction layer 22 or the second heat conduction layer 23 may be a heat conduction pad, silicone grease, or a phase change material (PCM). This is not limited herein.

It should be noted that at least one of the first heat conduction layer 22 and the second heat conduction layer 23 may alternatively be removed from the optical transceiver module 10, so that the chip 13 is in contact with the boss portion 18, and/or the optical component 14 is in contact with the inner side surface of the top wall 111 in the second region 16.

Still refer to FIG. 3. To fasten the heat sink 17 to the housing 11 and ensure that the top wall 111 of the housing 11 is not in contact with a bottom end surface of the heat sink 17, the optical transceiver module 10 may further include four elastic fastening members 30. The heat sink 17 is provided with four first through holes 171 through which the elastic fastening members 30 pass. One elastic fastening member 30 passes through each first through hole 171, and each elastic fastening member 30 may include a fastening portion 31 and an elastic portion 32. A first end of the fastening portion 31 passes through the first through hole 171 and is fastened to the housing 11, and a second end of the fastening portion 31 presses against a top end surface of the heat sink 17 by using the elastic portion 32, so that the elastic portion 32 enables the boss portion 18 to press against the first heat conduction layer 22 on the chip 13. In addition, the elastic portion 32 does not enables the bottom end surface of the heat sink 17 to be in contact with the top wall 111 in the height direction of the optical transceiver module 10, so that there is a gap between the top wall 111 and the bottom end surface of the heat sink 17.

The fastening portion 31 may be fastened to the top wall 111 or a bottom wall of the housing 11, to fasten the heat sink 17 to the housing 11. In addition, the fastening portion 31 may be in threaded connection with the housing 11, so that the fastening portion 31 is fastened to the housing 11. This is not limited herein. A quantity of elastic fastening members 30 includes but is not limited to four. For example, the quantity of elastic fastening members 30 may alternatively be two, three, or five. Therefore, there are at least two elastic fastening members 30.

It may be understood that, when the first heat conduction layer 22 is not disposed on the chip 13, under an action of the elastic portion 32, the chip 13 presses against the boss portion 18. Therefore, under elastic force of the elastic portion 32, the boss portion 18 may be in close contact with the chip 13 or the first heat conduction layer 22, so that a heat transfer effect between the chip 13 and the boss portion 18 can be improved, or a heat transfer effect between the chip 13 and the first heat conduction layer 22 can be improved. In this way, the heat dissipation capability of the chip 13 can be improved.

When the first heat conduction layer 22 is disposed between the chip 13 and the boss portion 18, because the boss portion 18 may be in close contact with the first heat conduction layer 22, the first heat conduction layer 22 may use a heat conduction material with lower thermal resistance. For example, the first heat conduction layer 22 may use an ultra-thin heat conduction pad. In addition, a thickness of the first heat conduction layer 22 may be further reduced. For example, the thickness of the first heat conduction layer 22 may be less than 0.3 mm. Therefore, under the action of the elastic portion 32, the first heat conduction layer 22 may use a heat conduction material with lower thermal resistance and a smaller thickness. This helps further improve the heat dissipation capability of the chip 13.

It should be noted that, because the elastic portion 32 may enable the boss portion 18 to be in close contact with the first heat conduction layer 22, an assembly tolerance may be absorbed, so that the first heat conduction layer 22 may use a heat conduction material with lower thermal resistance and a smaller thickness. The assembly tolerance refers to a tolerance chain formed by tolerances such as a height tolerance of the substrate 12, a tolerance generated after the chip 13 is mounted on the substrate 12, and a tolerance generated when the first heat conduction layer 22 is mounted on the chip 13.

When the elastic portion 32 presses against the heat sink 17 and the fastening portion 31, to avoid contact between the top wall 111 and the bottom end surface of the heat sink 17, in some examples, refer to FIG. 3. The elastic fastening member 30 may further include a pressing portion 33 disposed on the fastening portion 31. The top wall 111 is provided with a second through hole 113 that communicates with the receptacle 112. The fastening portion 31 passes through the second through hole 113, so that the pressing portion 33 is located in the receptacle 112, and the pressing portion 33 can press against the substrate 12. This can avoid contact between the bottom end surface of the heat sink 17 and the top wall 111 in the height direction of the optical transceiver module 10 caused when a length of the fastening portion 31 inserted into the receptacle 112 is excessively long. Certainly, that the bottom end surface of the heat sink 17 is disposed at an interval from the top wall 111 in the height direction of the optical transceiver module 10 may be ensured not through pressing of the pressing portion 33 against the substrate 12. For example, in some examples, a height of the boss portion 18 in the height direction of the optical transceiver module 10 may be controlled, to ensure that when the boss portion 18 presses against the chip 13, there is a gap between the top wall 111 and the bottom end surface of the heat sink 17 in the height direction of the optical transceiver module 10.

It should be noted that the top wall 111 may alternatively not be provided with the second through hole 113. In this case, the fastening portion 31 may pass through the through opening 15A, so that the pressing portion 33 can press against the substrate 12.

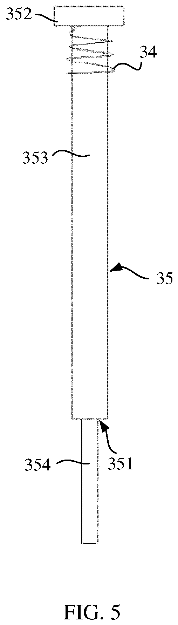

FIG. 5 is a diagram of a structure of an elastic fastening member according to an embodiment of this application. Refer to FIG. 3 and FIG. 5. In some possible implementations, the elastic fastening member 30 may include a spring 34 and a fastening screw 35, and a third through hole 121 into which the fastening screw 35 is inserted is disposed on the substrate 12. The spring 34 is sleeved on the fastening screw 35, and the spring 34 is the elastic portion 32 in the foregoing content. One end of the spring 34 presses against a screw cap 352 of the fastening screw 35, and the other end of the spring 34 presses against the top end surface of the heat sink 17. An outer wall of the fastening screw 35 defines a stop step surface 351 that presses against a top end surface of the substrate 12, that is, the stop step surface 351 is the pressing portion 33 in the foregoing content. The fastening screw 35 is the fastening portion 31 in the foregoing content. The fastening screw 35 passes through the first through hole 171, the second through hole 113, and the third through hole 121 in sequence, and is in threaded engagement with a fastening nut 25 disposed between the bottom wall of the housing 11 and the substrate 12. The fastening nut 25 is fastened to the bottom wall of the housing 11.

Still refer to FIG. 5. The fastening screw 35 may include the screw cap 352, a screw bolt 353, and a screw head 354. One end of the screw bolt 353 is fastened to the screw head 354 and is coaxially disposed with the screw head 354, and another end of the screw bolt 353 is fastened to the screw cap 352. The screw head 354 and the screw bolt 353 together define the stop step surface 351 that presses against the top end surface of the substrate 12. The screw head 354 is configured to be in threaded engagement with the fastening nut 25.

It should be noted that, in addition to being in engagement with the fastening nut 25 through the screw head 354, the fastening screw 35 may be further in threaded engagement with the top wall 111, to fasten the heat sink 17 and the top wall 111. In this case, the fastening screw 35 may also include the screw cap 352, the screw bolt 353, and the screw head 354. However, the screw head 354 is not provided with an external thread and is only configured to define the stop step surface 351 with the screw bolt 353.

Still refer to FIG. 3. The housing 11 may include an upper cover 114 and a bottom case 115. The upper cover 114 is disposed on a top end of the bottom case 115 and is fastened to the bottom case 115. The upper cover 114 and the bottom case 115 together define the receptacle 112. In addition, because the upper cover 114 is the top wall 111 of the housing 11, the through opening 15A is provided on the upper cover 114.

Still refer to FIG. 3. The heat sink 17 may include a main body portion 172 and a plurality of sheet-like portions 173. The plurality of sheet-like portions 173 are disposed at intervals along a length direction of the main body portion 172, and the plurality of sheet-like portions 173 are disposed on a first surface of the main body portion 172. The boss portion 18 is disposed on a second surface of the main body portion 172. The first surface and the second surface of the main body portion 172 are disposed opposite to each other along the height direction of the optical transceiver module 10. By using the heat sink 17 of such a structure, a heat exchange area between the heat sink 17 and air can be increased, and a heat dissipation capability of the heat sink 17 can be improved.

In this embodiment of this application, the substrate 12 may include but is not limited to a ceramic substrate 12 or a printed circuit board (Printed Circuit Board, PCB) 42. For example, in this embodiment of this application, the substrate 12 is the printed circuit board 42.

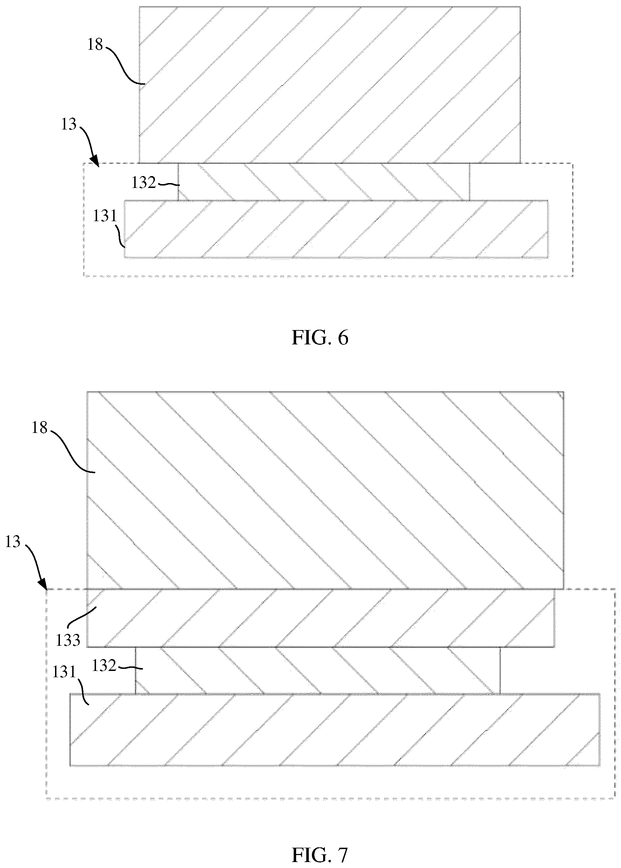

In this embodiment of this application, a structure of the chip 13 is not specifically limited herein. For example, FIG. 6 is a sectional view of cooperation between a chip and a boss portion according to an embodiment of this application. As shown in FIG. 6, the chip 13 may include a substrate layer 131 and a silicon wafer layer 132. The substrate layer 131 is configured to be mounted on the substrate 12, and the silicon wafer layer 132 is disposed on a surface of the substrate layer 131 and is configured to be in contact with the boss portion 18. Alternatively, FIG. 7 is another sectional view of cooperation between a chip and a boss portion according to an embodiment of this application. As shown in FIG. 7, in some examples, the chip 13 may include a substrate layer 131, a silicon wafer layer 132, and an encapsulation layer 133. The substrate layer 131 is configured to be mounted on the substrate 12, the silicon wafer layer 132 is disposed on a surface of the substrate layer 131, and the encapsulation layer 133 is disposed on a surface of the silicon wafer layer 132 and is configured to be in contact with the boss portion 18.

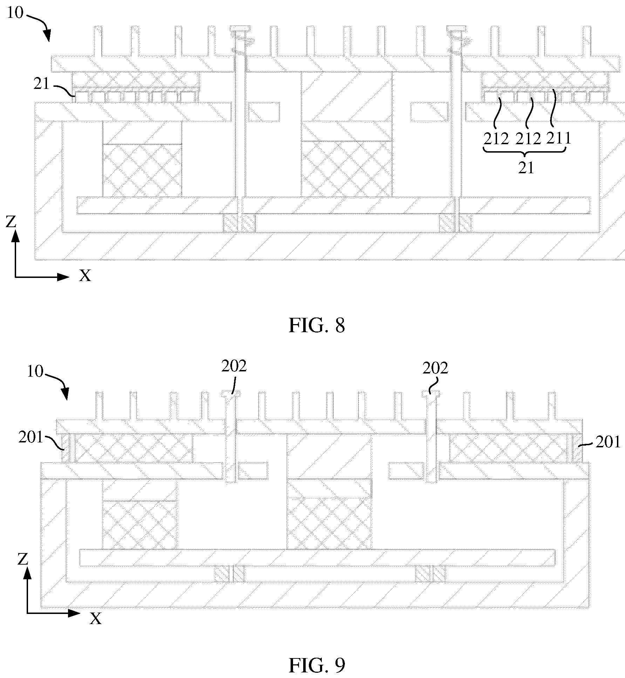

FIG. 8 is a sectional view of a second optical transceiver module according to an embodiment of this application. As shown in FIG. 8, a difference between FIG. 8 and FIG. 3 lies in that the optical transceiver module 10 further includes a heat sink fin portion 21 disposed on an outer side surface of the top wall 111 in the second region 16. In addition, the heat sink fin portion 21 is disposed at an interval from the bottom end surface of the heat sink 17 in the height direction of the optical transceiver module 10, so that a heat exchange area between the top wall 111 in the second region 16 and air can be increased, and the heat dissipation capability of the optical component 14 can be improved.

It should be noted that the heat sink fin portion 21 may cover the top wall 111 in the second region 16, or the heat sink fin portion 21 may cover a part of the top wall 111 in the second region 16. This is not specifically limited herein.

In this embodiment of this application, a specific structure of the heat sink fin portion 21 is not limited. For example, as shown in FIG. 8, the heat sink fin portion 21 may include a connecting sheet 211 and a plurality of heat sink sheets 212. The plurality of heat sink sheets 212 are disposed at intervals along a length direction of the connecting sheet 211. The plurality of heat sink sheets 212 are located between the top wall 111 and the connecting sheet 211. Two opposite ends of the heat sink sheet 212 are respectively fastened to the connecting sheet 211 and the top wall 111. Alternatively, the heat sink fin portion 21 may include a plurality of heat sink sheets 212 that are disposed at intervals along a length direction of the optical transceiver module 10, and there is a gap between the heat sink sheets 212 and the heat sink 17.

Alternatively, the heat sink 17 may not be fastened to the housing 11 by using the elastic fastening member 30. FIG. 9 is a sectional view of a third optical transceiver module according to an embodiment of this application. As shown in FIG. 9, a difference between FIG. 9 and FIG. 3 lies in that, through cooperation between a limiting post 201 and a fixing screw 202, the heat sink 17 is mounted on the housing 11. The fixing screw 202 passes through the first through hole 171 in the heat sink 17 and is in threaded connection with the top wall 111 of the housing 11, to fasten the heat sink 17 and the housing 11. The limiting post 201 is disposed between the heat sink 17 and the top wall 111 in the second region 16. In addition, under an action of the fixing screw 202, the limiting post 201 separately presses against the top wall 111 and the heat sink 17. A position of the heat sink 17 may be limited by the limiting post 201, to ensure that the bottom end surface of the heat sink 17 is disposed at an interval from the top wall 111 in the height direction of the optical transceiver module 10. In this way, the heat transferred from the heat sink 17 to the top wall 111 can be reduced, to prevent the optical component 14 from being baked by the heat generated by the chip 13.

There are at least two fixing screws 202. For example, in this embodiment of this application, there are four fixing screws 202, and the four fixing screws 202 are disposed around the through opening 15A. There are a plurality of limiting posts 201. For example, in this embodiment of this application, there may be four limiting posts 201, and the four limiting posts 201 are respectively disposed at four corners of the top wall 111.

It should be noted that a structure of the housing 11 is the same as a structure of the housing 11 in FIG. 3. Details are not described herein again. In addition, a heat sink fin portion 21 may also be disposed on the outer side surface of the top wall 111 in the second region 16, so that the heat dissipation capability of the optical component 14 can be improved.

In the foregoing content, the chip 13 dissipates heat outside the housing 11 through the heat sink 17, and the optical component 14 dissipates heat outside the housing 11 through the top wall 111 in the second region 16. However, the chip 13 may alternatively dissipate heat outside the housing 11 through the top wall in the first region 15, and the optical component 14 dissipates heat outside the housing 11 through the heat sink 17.

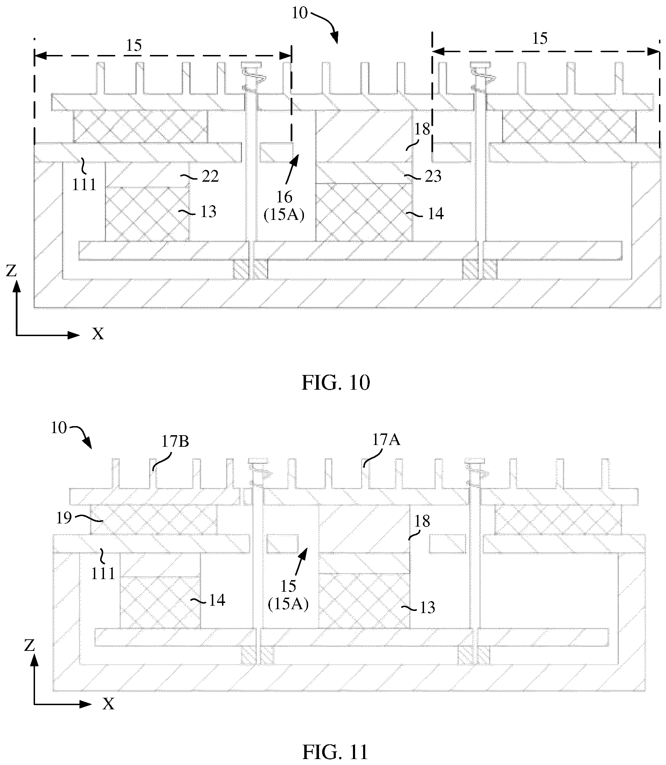

FIG. 10 is a sectional view of a fourth optical transceiver module according to an embodiment of this application. As shown in FIG. 10, a difference between FIG. 10 and FIG. 3 lies in that the second region 16 is the through opening 15A that penetrates the top wall 111 of the housing 11, and the first region 15 is the region other than the through opening 15A of the top wall 111. The chip 13 is in contact with the inner side surface of the top wall 111 in the first region 15 through the first heat conduction layer 22. The heat sink 17 is in contact with the optical component 14 through the boss portion 18 passing through the through opening 15A, so that the heat sink 17 dissipates heat for the optical component 14. Certainly, the heat sink fin portion 21 in the foregoing content may also be disposed on an outer side surface of the top wall 111 in the first region 15, to improve the heat dissipation capability of the chip 13.

In the foregoing content, the optical transceiver module 10 includes one heat sink 17, and the chip 13 dissipates heat through the heat sink 17. The heat dissipation capability of the optical component 14 is improved by disposing the heat sink fin portion 21. However, the heat dissipation capability of the optical component 14 may alternatively be improved by using the heat sink 17. For example, FIG. 11 is a sectional view of a fifth optical transceiver module according to an embodiment of this application. As shown in FIG. 11, a difference between FIG. 11 and FIG. 3 lies in that there are two heat sinks 17. The heat sink 17A is in contact with the chip 13 through the boss portion 18, so that the heat sink 17A separately dissipates heat for the chip 13. The heat sink 17B is in contact with the outer side surface of the top wall 111 in the second region 16 through the heat insulation layer 19, so that the heat sink 17B separately dissipates heat for the optical component 14. Therefore, the heat dissipation capability of the optical transceiver module 10 can be further improved by disposing the two heat sinks 17.

It should be noted that the two heat sinks 17 may be in contact with each other or may not be in contact with each other. This is not specifically limited herein. Refer to FIG. 11. For example, the heat sink 17A is disposed at an interval from the heat sink 17B in the length direction of the optical transceiver module 10, so that the two heat sinks 17 are not in contact with each other, and further, no heat is transferred between the two heat sinks 17. This helps improve the heat dissipation capability of the optical transceiver module 10.

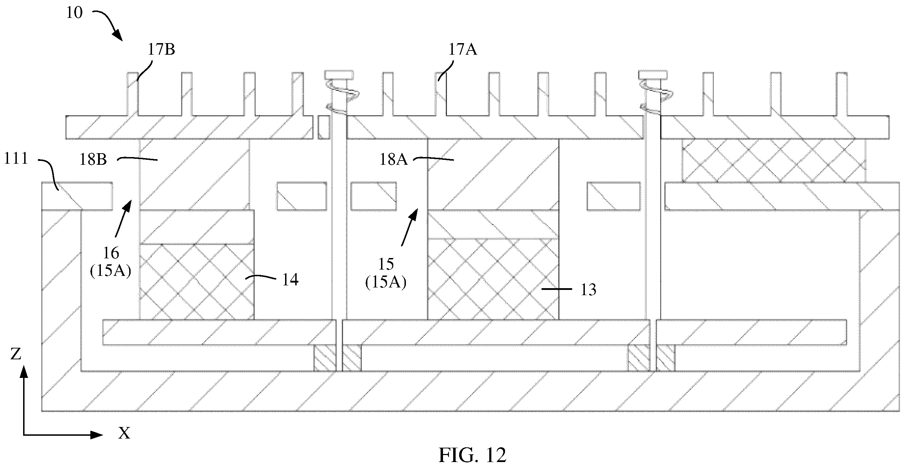

In the foregoing content, the top wall 111 is provided with one through opening 15A, so that one of the chip 13 and the optical component 14 can be in contact with the heat sink 17 through the boss portion 18. However, both the chip 13 and the optical component 14 may be in contact with the heat sink 17 through the boss portion 18. For example, FIG. 12 is a sectional view of a sixth optical transceiver module according to an embodiment of this application. As shown in FIG. 12, a difference between FIG. 12 and FIG. 3 lies in that the optical transceiver module 10 includes two heat sinks 17 and two boss portions 18. The second region 16 is also the through opening 15A that penetrates the top wall 111. The heat sink 17A is in contact with the first heat conduction layer 22 on the chip 13 through the boss portion 18A, and the heat sink 17B is in contact with the second heat conduction layer 23 on the optical component 14 through the boss portion 18B. In this way, the heat dissipation capability of the optical transceiver module 10 can be further improved.

In the foregoing content, the top wall 111 of the housing 11 is provided with at least one through opening 15A, so that at least one of the chip 13 and the optical component 14 can exchange heat with the heat sink 17. However, the through opening 15A may alternatively not be provided, that is, the chip 13 or the optical component 14 exchanges heat with the heat sink 17 through the top wall 111.

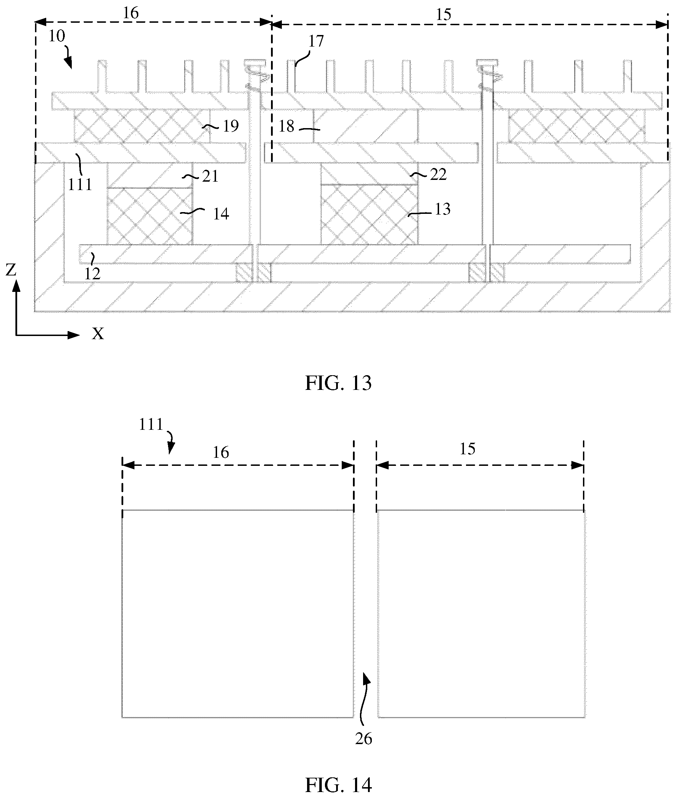

FIG. 13 is a sectional view of a seventh optical transceiver module according to an embodiment of this application. As shown in FIG. 13, a difference between FIG. 13 and FIG. 3 lies in that the first region 15 is a part of the top wall 111, and the second region 16 is a part of the top wall 111. The chip 13 is in contact with the inner side surface of the top wall 111 in the first region 15 through the first heat conduction layer 22. The optical component 14 is in contact with the inner side surface of the top wall 111 in the second region 16 through the second heat conduction layer 23. The heat sink 17 is in contact with the outer side surface of the top wall 111 in the first region 15 through the boss portion 18.

When a volume of the heat sink 17 is large, and a part of the heat sink 17 is located in the second region 16, the heat insulation layer 19 may be disposed between the top wall in the second region 16 and the heat sink 17, to prevent the heat on the heat sink 17 from being transferred to the top wall 111 and then to the optical component 14. Certainly, when the material of the heat insulation layer 19 is air, in the height direction of the optical transceiver module 10, a bottom end surface of the part that is of the heat sink 17 and that is located in the second region 16 is disposed at an interval from the top wall 111 in the second region 16, to reduce the heat transferred from the heat sink 17 to the top wall 111 in the second region 16.

It should be noted that the heat sink 17 may alternatively be removed from the optical transceiver module 10, and the chip 13 dissipates heat outside the housing 11 through the top wall in the first region 15. In addition, when the heat sink 17 is removed, the heat sink fin portion 21 in the foregoing content may also be disposed on the outer side surface of the top wall in the first region 15. It should be further noted that the heat sink fin portion 21 in the foregoing content may also be disposed on the outer side surface of the top wall 111 in the second region 16.

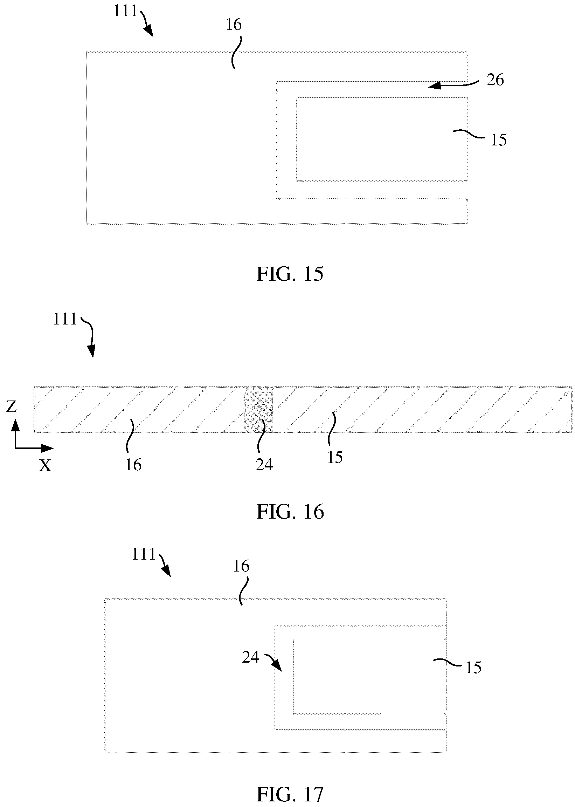

FIG. 14 is a top view of a first top wall according to an embodiment of this application. FIG. 15 is a top view of a second top wall according to an embodiment of this application. Refer to FIG. 14 and FIG. 15. In some possible implementations, the top wall 111 is provided with a heat insulation hole 26 that communicates with the receptacle 112, and the heat insulation hole 26 is provided between the first region 15 and the second region 16. The first region 15 and the second region 16 may be heat-insulated from each other by using the heat insulation hole 26. The heat insulation hole 26 may be a closed annular hole, or the heat insulation hole 26 may be an unclosed annular hole, or the heat insulation hole 26 may be a strip-shaped hole. This is not specifically limited herein. For example, the heat insulation hole 26 is a linear strip-shaped hole (as shown in FIG. 14) provided between the first region 15 and the second region 16, or the heat insulation hole 26 is a U-shaped hole (as shown in FIG. 15). It may be understood that a larger width of the heat insulation hole 26 indicates a better heat insulation effect of the heat insulation hole 26. This helps reduce the heat transferred between the first region 15 and the second region 16.

FIG. 16 is a sectional view of a third top wall according to an embodiment of this application. FIG. 17 is a top view of a fourth top wall according to an embodiment of this application. Certainly, in addition to implementing heat insulation between the first region 15 and the second region 16 by using the heat insulation hole 26, in some possible implementations, refer to FIG. 15 or FIG. 16. The top wall 111 may further include a heat insulation portion 24 made of a heat insulation material. The heat insulation portion 24 is disposed between the first region 15 and the second region 16. Because the heat insulation portion 24 is made of the heat insulation material, thermal resistance between the first region 15 and the second region 16 can be increased. In this way, the heat transferred between the first region 15 and the second region 16 can be reduced, to prevent the optical component 14 from being baked by the heat generated by the chip 13. A material of the heat insulation portion 24 is the heat insulation material, for example, the material of the heat insulation portion 24 may be silicone rubber. In addition, a shape of the heat insulation portion 24 is not specifically limited herein. For example, the heat insulation portion 24 may be a linear strip-shaped structure, or the heat insulation portion 24 may be U-shaped (for example, as shown in FIG. 17). Certainly, the heat insulation portion 24 may alternatively be an annular structure.

It should be noted that, to improve the heat dissipation capability of the optical component 14, the heat sink fin portion 21 in the foregoing content may also be disposed on the outer side surface of the top wall 111 in the second region 16, to improve the heat dissipation capability of the optical component 14.

In FIG. 13, the heat sink 17 is configured to dissipate heat for the chip 13, and the optical component 14 dissipates heat outside the housing 11 through the top wall in the second region 16. However, the heat sink 17 may also be configured to dissipate heat for the optical component 14. In this case, the heat sink 17 is in contact with the outer side surface of the top wall 111 in the second region 16 through the boss portion 18, and the chip 13 dissipates heat outside the housing 11 through the top wall 111 in the first region 15. In addition, when a part of the heat sink 17 is located in the first region 15, the heat insulation layer 19 may be disposed between the heat sink 17 and the top wall in the first region 15. When the material of the heat insulation layer 19 is air, a bottom end surface of the part that is of the heat sink 17 and that is located in the first region 15 is disposed at an interval from the top wall 111 in the first region 15 in the height direction of the optical transceiver module 10.

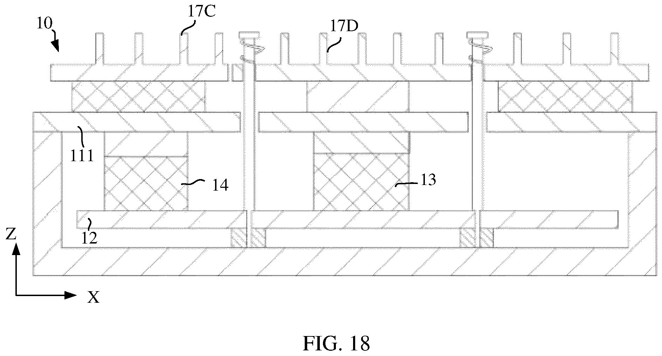

It should be noted that, in some examples, the optical component 14 and the chip 13 may alternatively use a same heat sink 17 to dissipate heat. In this case, the heat insulation layer 19 may not be disposed between the heat sink 17 and the top wall 111 in the second region 16. Certainly, in some examples, the optical component 14 and the chip 13 may respectively use different heat sinks 17 to dissipate heat. For example, FIG. 18 is a sectional view of an eighth optical transceiver module according to an embodiment of this application. As shown in FIG. 18, a difference between FIG. 18 and FIG. 13 lies in that there are two heat sinks 117. The heat sink 17D is configured to be in contact with the outer side surface of the top wall 111 in the first region 15, and the heat sink 17C is configured to be in contact with the outer side surface of the top wall 111 in the second region 16. The heat sink 17C and the heat sink 17D may be in contact with each other or may not be in contact with each other. This is not limited herein.

In the descriptions of embodiments of this application, it should be noted that, unless otherwise explicitly stipulated and restricted, terms "mount", "connect to", and "connection" should be understood in a board sense, which, for example, may be a fixed connection, or may be an indirect connection through an intermediate medium, or may be an internal connection between two elements, or may be an interaction relationship between two elements. A person of ordinary skill in the art may understand specific meanings of the foregoing terms in embodiments of this application based on specific cases.

In embodiments of this application, it is implied that an apparatus or element in question needs to have a particular orientation, or needs to be constructed and operated in a particular orientation, and therefore cannot be construed as a limitation on embodiments of this application. In the descriptions of embodiments of this application, unless otherwise exactly and specifically ruled, "a plurality of" means two or more than two.

In the specification, claims, and accompanying drawings of embodiments of this application, the terms "first", "second", "third", "fourth", and so on (if existent) are intended to distinguish between similar objects but do not necessarily indicate a specific order or sequence. It should be understood that data used in such a way is interchangeable in a proper circumstance, so that embodiments of this application described herein can be implemented in other orders than the order illustrated or described herein. In addition, terms "include" and "have" and any other variants are intended to cover non-exclusive inclusions. For example, a process, method, system, product, or device that includes a list of steps or units is not necessarily limited to those expressly listed steps or units, but may include other steps or units not expressly listed or inherent to such a process, method, product, or device.

The term "a plurality of" in this specification means two or more. The term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

It may be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

## Claims

1. An optical transceiver module, comprising a housing, a substrate, and a chip and an optical component that are mounted on the substrate, wherein
the housing has a receptacle that accommodates the chip, the optical component, and the substrate, and a top wall of the housing has a first region and a second region that are heat-insulated from each other; and
one of the chip and the optical component dissipates heat outside the housing through the first region, and the other of the chip and the optical component dissipates heat outside the housing through the second region.

2. The optical transceiver module according to claim 1, further comprising a heat sink, wherein the heat sink is mounted on the housing and is configured to dissipate heat for one of the chip and the optical component.

3. The optical transceiver module according to claim 2, wherein the first region is a through opening that penetrates the top wall, and the through opening communicates with the receptacle;
the heat sink is disposed at an interval from the top wall along a height direction of the optical transceiver module, the heat sink exchanges heat with one of the chip and the optical component through a boss portion that passes through the through opening, and there is a gap between a side wall of the boss portion and an inner wall of the through opening; and
the other of the chip and the optical component is in contact with an inner side surface of the top wall in the second region.

4. The optical transceiver module according to claim 3, further comprising a heat insulation layer, wherein the heat insulation layer is disposed between the heat sink and the top wall in the second region.

5. The optical transceiver module according to claim 3 or 4, further comprising an elastic fastening member, wherein the heat sink is provided with a first through hole that penetrates the heat sink;
the elastic fastening member comprises a fastening portion and an elastic portion;
a first end of the fastening portion passes through the first through hole and is fastened to the housing, a second end of the fastening portion presses against a top end surface of the heat sink by using the elastic portion, and a bottom end surface of the heat sink is disposed at an interval from the top wall in the height direction of the optical transceiver module; and
the elastic portion is configured to enable the boss portion to press against one of the chip and the optical component.

6. The optical transceiver module according to claim 5, wherein the elastic fastening member further comprises a pressing portion disposed on the fastening portion; the top wall is provided with a second through hole that communicates with the receptacle; the fastening portion passes through the second through hole and is fastened to the housing; and the pressing portion is configured to press against the substrate, so that the bottom end surface of the heat sink is disposed at an interval from the top wall in the height direction of the optical transceiver module.

7. The optical transceiver module according to claim 3 or 4, further comprising a limiting post and a fixing screw, wherein
the limiting post is disposed between the heat sink and the top wall, and separately presses against the top wall and the heat sink, so that a bottom end surface of the heat sink is disposed at an interval from the top wall in the height direction of the optical transceiver module; and
the heat sink is fastened to the housing by using the fixing screw.

8. The optical transceiver module according to any one of claims 3 to 7, wherein a heat sink fin portion is disposed on an outer side surface of the top wall in the second region, and the heat sink fin portion is disposed at an interval from the heat sink in the height direction of the optical transceiver module.

9. The optical transceiver module according to any one of claims 3 to 8, further comprising a first heat conduction layer and a second heat conduction layer, wherein
the first heat conduction layer covers a surface of the chip and is configured to exchange heat with the boss portion or the top wall in the second region; and
the second heat conduction layer covers a surface of the optical component and is configured to exchange heat with the boss portion or the top wall in the second region.

10. The optical transceiver module according to any one of claims 3 to 9, wherein the chip of the chip and the optical component is in contact with the boss portion, and the optical component of the chip and the optical component is in contact with the inner side surface of the top wall in the second region.

11. The optical transceiver module according to claim 1 or 2, wherein one of the chip and the optical component is in contact with an inner side surface of the top wall in the first region, and the other of the chip and the optical component is in contact with an inner side surface of the top wall in the second region.

12. The optical transceiver module according to claim 11, wherein the top wall is provided with a heat insulation hole that communicates with the receptacle, and the heat insulation hole is provided between the first region and the second region.

13. The optical transceiver module according to claim 11, wherein the top wall further comprises a heat insulation portion made of a heat insulation material, and the heat insulation portion is disposed between the first region and the second region.

14. A communication device, comprising a board and the optical transceiver module according to any one of claims 1 to 13, wherein the optical transceiver module is mounted on the board.
